# EUROPEAN PATENT APPLICATION

(11) **EP 4 852 673 A1**
(43) Date of publication of application: **09.12.2026**
(21) Application number: 25747758.8
(22) Date of filing: 23.01.2025
(51) Int. Cl.: H10H 29/30, H10H 29/855, H10H 29/856

(54) **LED DISPLAY SUBSTRATE AND LED DISPLAY DEVICE**

(30) Priority: 02.02.2024 CN 202410154148
(71) Applicant: Ningbo QiuShui Semiconductor Technology Co., Ltd., Ningbo, Zhejiang (CN)
(72) Inventor: JIANG, Zhenyu, Ningbo, Zhejiang (CN)
(74) Representative: De Arpe Tejero, Manuel
(86) International application number: PCT/CN2025/074386
(87) International publication number: WO 2025/162189

(57) **Abstract**

The present application discloses an LED display substrate and an LED display device. The LED display substrate comprises a light-emitting epitaxial layer, a first dielectric cladding layer, a reflective layer, and a plurality of reflective electrodes, wherein the light-emitting epitaxial layer comprises a first semiconductor layer, an active layer, and a second semiconductor layer; a first main recessed area and a plurality of first boss structures are formed on the first semiconductor layer; the first dielectric cladding layer is arranged in the first main recessed area and is in contact with the side walls of the first boss structures; the refractive index of the first dielectric cladding layer is different from that of the first semiconductor layer; the reflective layer is arranged on the side of one of the first semiconductor layer and the second semiconductor layer facing away from the active layer; the reflective electrodes are arranged on the other one of the first semiconductor layer and the second semiconductor layer facing away from the active layer; and the reflectivity of the reflective layer is less than that of the reflective electrodes, so as to form a resonant cavity emitting light from one side of the reflective layer. By means of the method, the present application can make the light emitted by the LED display substrate more collimated, and can improve the light-emitting efficiency of the LED display substrate.

## Description

### TECHNICAL FIELD

Some embodiments of the present disclosure relate to the field of semiconductor light-emitting diode (LED) technology, and in particular to an LED display substrate and an LED display device.

### BACKGROUND

An LED, which is a semiconductor component capable of converting electrical energy into visible light, is a light source widely applied in modern times to indication, display, decoration, backlight sources, general illumination, urban night scenes, and other fields. With the development of technology, a light-emitting chip that mainly emits light in the LED may have achieved a micrometer scale, such that the light-emitting chip of the LED may have a smaller size. However, as the light-emitting chip of the LED miniaturized to the micrometer scale decreases in size, the light emission intensity at an edge may increase accordingly. In this way, a size effect generated may affect the collimation of emitted light and may further reduce the optical efficiency of a system.

### SUMMARY OF THE DISCLOSURE

Some embodiments of the present disclosure provide an LED display substrate and an LED display device, which may enable the LED display substrate to have relatively collimated light output and improve the light-emitting efficiency of the LED display substrate.

In a first aspect, some embodiments of the present disclosure provide an LED display substrate. The LED display substrate includes a light-emitting epitaxial layer, a first dielectric cladding layer, a reflective layer, and a plurality of reflective electrodes.

The light-emitting epitaxial layer includes a first semiconductor layer, an active layer, and a second semiconductor layer sequentially stacked on one another. A side of the first semiconductor layer away from the active layer defines a first main recessed region and a plurality of first mesa structures. The plurality of first mesa structures are arranged in an array and spaced apart from each other by the first main recessed region. A depth of the first main recessed region is less than or equal to a thickness of the first semiconductor layer at the first mesa structures.

The first dielectric cladding layer is disposed in the first main recessed region and is in contact with sidewalls of the first mesa structures. A refractive index of the first dielectric cladding layer is different from a refractive index of the first semiconductor layer, so as to form a reflective interface between the first dielectric cladding layer and the sidewalls of the first mesa structures.

The reflective layer is disposed on a side of one of the first semiconductor layer and the second semiconductor layer facing away from the active layer.

The plurality of reflective electrodes are arranged in an array at intervals on a side of the other one of the first semiconductor layer and the second semiconductor layer facing away from the active layer. The plurality of reflective electrodes respectively correspond to the plurality of first mesa structures. A reflectivity of the reflective layer is less than a reflectivity of the reflective electrodes, so as to form a resonant cavity that is configured to emit light from a side of the reflective layer.

In a second aspect, some embodiments of the present disclosure provide an LED display device. The LED display device includes the LED display substrate according to any of the above embodiments and a driving substrate. The driving substrate includes a plurality of power supply electrodes arranged in an array at intervals. The LED display substrate is fixed on the driving substrate, and the power supply electrodes are electrically connected to the corresponding reflective electrodes, so as to form display pixels corresponding to the first mesa structures.

Some technical effects of the present disclosure may be as follows. Different from the related art, in some embodiments of the present disclosure, the first semiconductor layer of the light-emitting epitaxial layer for generating light is provided with the first main recessed region to form the plurality of first mesa structures. The reflective layer and the plurality of reflective electrodes are disposed on two sides of the plurality of first mesa structures, so that the plurality of first mesa structures may form a plurality of display pixels. The reflectivity of the reflective layer is less than the reflectivity of the reflective electrodes, so that the reflective electrodes may reflect light from the light-emitting epitaxial layer to a side of the reflective layer, thereby enabling the light-emitting epitaxial layer at the plurality of first mesa structures to form the resonant cavity that is configured to emit light from the side of the reflective layer. In this way, collimation of light output of the LED display substrate may be improved, and light-emitting efficiency may be improved. Furthermore, in some embodiments of the present disclosure, the first dielectric cladding layer may be disposed in the first main recessed region. The first dielectric cladding layer may be disposed to be in contact with the sidewalls of the first mesa structures. The refractive index of the first dielectric cladding layer may be configured to be different from the refractive index of the first semiconductor layer, so that a reflective interface may be formed at the sidewalls of the first mesa structures. In a case where display pixels corresponding to the first mesa structures emit light, the first dielectric cladding layer may be configured to reflect, at the sidewalls of the first mesa structures, light generated within the first mesa structures back into the resonant cavity. The reflective electrodes having higher reflectivity may be configured to further reflect the light to a side of the reflective layer, thereby reducing light leakage from the sidewalls of the first mesa structures, and further improving collimation of light output and improving light-emitting efficiency of the LED display substrate.

### BRIEF DESCRIPTION OF THE DRAWINGS

FIG. 1 is a schematic structural view of an LED display device according to some embodiments of the present disclosure.
FIG. 2 is a schematic structural view of the LED display device according to some other embodiments of the present disclosure.
FIG. 3 is a schematic structural view of the LED display device according to yet some other embodiments of the present disclosure.
FIG. 4 is a schematic structural view of the LED display device according to still some other embodiments of the present disclosure.
FIG. 5 is a schematic diagram comparing light output effects of two embodiments of the LED display device according to the present disclosure.

### DETAILED DESCRIPTION

The technical solutions in the embodiments of the present disclosure may be clearly and completely described below with reference to the accompanying drawings in the embodiments of the present disclosure. Apparently, the described embodiments may be only part of the embodiments of the present disclosure, rather than all of the embodiments. Based on the embodiments of the present disclosure, all other embodiments obtained by those skilled in the art without making inventive efforts shall fall within the protection scope of the present disclosure.

The inventor of the present disclosure has found through research that an LED, which is a semiconductor component capable of converting electrical energy into visible light, is a light source widely applied in modern times to indication, display, decoration, backlight sources, general illumination, urban night scenes, and other fields. With the development of technology, a light-emitting chip that mainly emits light in an LED may have achieved a micrometer scale, such that the light-emitting chip of the LED may have a smaller size. However, as the light-emitting chip of the LED miniaturized to the micrometer scale decreases in size, the light emission intensity at an edge may increase accordingly. In this way, a size effect generated may affect the collimation of emitted light and may further reduce the optical efficiency of a system. In order to solve the above problems, the following embodiments are provided in the present disclosure.

The following embodiments of an LED display device may exemplarily describe the LED display device of the present disclosure.

The LED display device 10 may refer to a device capable of forming a plurality of display pixels therein to generate light. The light generated by the LED display device 10 may be configured to emit from a surface of the LED display device 10 and to illuminate or display various information such as text and images, etc. For example, the LED display device 10 may be an LED display panel chip, an LED digital vehicle lamp chip, a digital light strip chip, or other devices.

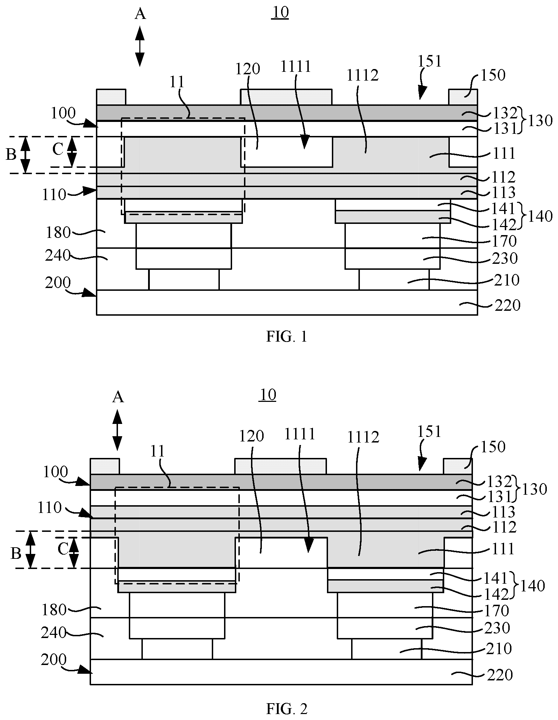

As shown in FIG. 1 and FIG. 2, the LED display device 10 may include, for example, an LED display substrate 100 and a driving substrate 200. The driving substrate 200 may be configured to provide electrical energy to the LED display substrate 100. The LED display substrate 100 may be configured to receive the electrical energy from the driving substrate 200, so as to form a plurality of display pixels therein to generate light.

In some embodiments, as shown in FIG. 1 and FIG. 2, the LED display substrate 100 may include a light-emitting epitaxial layer 110, a first dielectric cladding layer 120, a reflective layer 130, and a plurality of reflective electrodes 140.

The light-emitting epitaxial layer 110 may be configured, under an action of a driving voltage, to perform a recombination of electrons and holes to emit light, and to define a plurality of display pixels.

Further, as shown in FIG. 1 and FIG. 2, the light-emitting epitaxial layer 110 may include a first semiconductor layer 111, an active layer 112, and a second semiconductor layer 113 sequentially stacked on one another.

One of the first semiconductor layer 111 and the second semiconductor layer 113 may be an N-type semiconductor layer. The other of the first semiconductor layer 111 and the second semiconductor layer 113 may be a P-type semiconductor layer. The active layer 112 may be a working medium layer. The first semiconductor layer 111 and the second semiconductor layer 113 may be respectively located on two side surfaces of the active layer 112 and may be in contact with the active layer 112. The active layer 112 together with the first semiconductor layer 111 and the second semiconductor layer 113 on both sides, may form an N-i-P heterostructure, where a recombination of electrons and holes may be performed to form a P-N junction, so as to form one or more display pixels.

In some embodiments, the first semiconductor layer 111, the active layer 112, and the second semiconductor layer 113 may be formed through doping semiconductor materials such as AlN, AlGaN, GaN, InGaN, AlInGaN, GaAs, GaP, GaInN, GaAsP, AlGaAs, AlGaInP, and the like.

A side of the first semiconductor layer 111 away from the active layer 112 may define a first main recessed region 1111 and a plurality of first mesa structures 1112. The plurality of first mesa structures 1112 may be arranged in an array and may be spaced apart from each other by the first main recessed region 1111. A depth of the first main recessed region 1111 may be less than or equal to a thickness of the first semiconductor layer 111 at the first mesa structures 1112.

In some embodiments, a side of the first semiconductor layer 111 away from the active layer 112 may be etched to form a plurality of first main recessed regions 1111. The first main recessed regions 1111 may be spaced from each other, which forms the first mesa structures 1112 arranged in an array. The array arrangement of the plurality of first mesa structures 1112 may be consistent with an array arrangement of a plurality of desired display pixels, so that the plurality of first mesa structures 1112 may define the plurality of display pixels.

The arrangement in which the depth of the first main recessed region 1111 is less than or equal to the thickness of the first semiconductor layer 111 at the first mesa structures 1112, may allow the active layer 112 less likely to be damaged during etching of the first main recessed region 1111, thereby ensuring the light emission intensity of the light-emitting epitaxial layer 110. As shown in FIG. 1 or FIG. 2, in a thickness direction A of the LED display device 10, the depth of the first main recessed region 1111 is shown as depth C in FIG. 1 and FIG. 2, and the thickness of the first semiconductor layer 111 at the first mesa structures 1112 is shown as thickness B in FIG. 1 and FIG. 2, where C≤B.

For example, in some embodiments, the depth of the first main recessed region 1111 may be less than the thickness of the first semiconductor layer 111 at the first mesa structures 1112, so that the light-emitting epitaxial layer 110 corresponding to the first main recessed region 1111 may include the first semiconductor layer 111. During a process of the LED display substrate 100 being energized to emit light, current may diffuse, through the first semiconductor layer 111 corresponding to the first main recessed region 1111, to the first semiconductor layer 111 corresponding to other display pixels.

Further, as shown in FIG. 1 and FIG. 2, the first dielectric cladding layer 120 may be disposed in the first main recessed region 1111 and may be in contact with sidewalls of the first mesa structures 1112. A refractive index of the first dielectric cladding layer 120 may be different from a refractive index of the first semiconductor layer 111, thereby forming a reflective interface between the first dielectric cladding layer 120 and the sidewall of the first mesa structure 1112.

The first dielectric cladding layer 120 may include a cladding material. For example, the first dielectric cladding layer 120 may include a dielectric material, such as SiO2 or TiO2, etc.

In some embodiments, the reflective interface formed between the first dielectric cladding layer 120 and the sidewall of the first mesa structure 1112 may be configured to reflect light inside the first mesa structure 1112, so that light generated by display pixel corresponding to the first mesa structure 1112 may be reflected back into the first mesa structure 1112 when propagating to the first dielectric cladding layer 120.

In some embodiments, as shown in FIG. 1 and FIG. 2, the first dielectric cladding layer 120 may be configured to be in full contact with the sidewall of the first mesa structure 1112 along a circumferential direction of the first mesa structure 1112.

With the above arrangement, when light generated by display pixel corresponding to the first mesa structure 1112 propagates to the sidewall of the first mesa structure 1112, the light may be reflected back into the first mesa structure 1112 to a great extent, thereby reducing light leakage from a direction of the sidewall of the first mesa structure 1112 and enhancing light-emitting efficiency of the LED display substrate 100.

In some embodiments, an absolute value of a difference between the refractive index of the first dielectric cladding layer 120 and the refractive index of the first semiconductor layer 111 may be not less than 0.8. In some embodiments, the first dielectric cladding layer 120 may be disposed in the first main recessed region 1111 and may be in contact with the first semiconductor layer 111 in the first mesa structures 1112. Through setting the absolute value of the difference between the refractive indices of the first dielectric cladding layer 120 and the first semiconductor layer 111 to be not less than 0.8, the reflective interface formed between the first dielectric cladding layer 120 and the sidewall of the first mesa structures 1112 may have a strong reflection function, thereby better reflecting light propagating to the sidewalls of the first mesa structures 1112 and greatly reducing light leakage.

For example, a preparation material of the first dielectric cladding layer 120 may be silicon dioxide, with an approximate refractive index of 1.45-1.50. A preparation material of the first semiconductor layer 111 may be gallium nitride, with an approximate refractive index of 2.3-2.4. An absolute value of the difference between the refractive index of the first dielectric cladding layer 120 and the refractive index of the first semiconductor layer 111 may be 0.8-0.95.

In some embodiments, the first dielectric cladding layer 120 may be formed through a deposition manner. In some embodiments, during a preparation process of the LED display substrate 100, after the first main recessed regions 1111 are etched to form the plurality of first mesa structures 1112, the first dielectric cladding layer 120 may be deposited in the first main recessed regions 1111. In this way, the first dielectric cladding layer 120 may be in full contact with the sidewalls of the first mesa structures 1112 along the circumferential direction of the first mesa structures 1112. Forming the first dielectric cladding layer 120 through the deposition manner may simplify a preparation process of the LED display substrate 100 and reduce a preparation difficulty of the LED display substrate 100.

Further, as shown in FIG. 1 and FIG. 2, the reflective layer 130 may be disposed on a side of one of the first semiconductor layer 111 and the second semiconductor layer 113 away from the active layer 112. The plurality of reflective electrodes 140 may be arranged in an array at intervals on a side of the other one of the first semiconductor layer 111 and the second semiconductor layer 113 away from the active layer 112, and may respectively correspond to the plurality of first mesa structures 1112. A reflectivity of the reflective layer 130 may be less than a reflectivity of the reflective electrode 140, so as to form a resonant cavity 11 that is configured to emit light from a side of the reflective layer 130.

The reflective layer 130 and the plurality of reflective electrodes 140 may correspond to the plurality of first mesa structures 1112. The reflective layer 130 may be configured as an N electrode of the LED display substrate 100, and the reflective electrode 140 may be configured as a P electrode of the LED display substrate 100. In this way, display pixels corresponding to the plurality of first mesa structures 1112 in the LED display substrate 100, may be configured to emit light under an action of the reflective layer 130 and the reflective electrodes 140.

In some embodiments, as shown in FIG. 1 and FIG. 2, the driving substrate 200 may include a plurality of power supply electrodes 210 arranged in an array at intervals. The LED display substrate 100 may be fixed on the driving substrate 200, and the power supply electrodes 210 may be electrically connected to the corresponding reflective electrodes 140, so as to form display pixels corresponding to the first mesa structures 1112.

In some embodiments, the plurality of power supply electrodes 210 may correspond to the plurality of reflective electrodes 140. The driving substrate 200 may be configured to conduct a driving current to the reflective electrodes 140 through the power supply electrodes 210. The driving current may be configured to flow to the light-emitting epitaxial layer 110 through the reflective electrodes 140 to drive the light-emitting epitaxial layer 110 to perform a light-emitting function. With the above arrangement, the LED display device 10 may achieve precise control of individual display pixels through the plurality of power supply electrodes 210 and the plurality of reflective electrodes 140, thereby improving and enriching a display effect of the LED display substrate 100.

In some embodiments, as shown in FIG. 1 and FIG. 2, both the reflective layer 130 and the reflective electrodes 140 may have a double-layer structure including a conductive layer and a mirror layer. In some embodiments, the reflective layer 130 may include a first conductive layer 131 and a first mirror layer 132 sequentially stacked on one another in the thickness direction A. The reflective electrodes 140 may include a second conductive layer 141 and a second mirror layer 142 sequentially stacked on one another in the thickness direction A.

The first conductive layer 131 may be disposed on a side of one of the first semiconductor layer 111 and the second semiconductor layer 113 away from the active layer 112. The second conductive layer 141 may be disposed on a side of the other one of the first semiconductor layer 111 and the second semiconductor layer 113 away from the active layer 112. The first mirror layer 132 may be disposed on a side of the first conductive layer 131 facing away from the light-emitting epitaxial layer 110. The second mirror layer 142 may be disposed on a side of the second conductive layer 141 facing away from the light-emitting epitaxial layer 110 and may be electrically connected to the power supply electrodes 210.

In some embodiments, the first conductive layer 131 may be a transparent metal layer, for example, an indium tin oxide (ITO) layer, or may be a metal layer formed through doping a multilayer metal composed of aluminum together with metals such as titanium, chromium, etc. The second conductive layer 141 may be an ITO layer or a metal aluminum layer, or may be a metal layer formed through doping a multilayer metal composed of aluminum together with metals such as titanium, chromium, etc. The first conductive layer 131 and the second conductive layer 141 may respectively form bonding structures with the light-emitting epitaxial layer 110 to form ohmic contact. The first conductive layer 131 and the second conductive layer 141 may further be respectively configured as a P electrode and an N electrode of the light-emitting epitaxial layer 110. In this way, when the LED display substrate 100 is energized to emit light, propagation and diffusion of current may be enhanced, thereby enhancing a light-emitting effect of the LED display substrate 100.

In some embodiments, the first mirror layer 132 may be a distributed bragg reflector (DBR) mirror, which may have a multilayer SiO2/TiO2 dielectric film structure. The second mirror layer 142 may be a DBR mirror, or may be a metal aluminum layer. A reflectivity of the second mirror layer 142 may be greater than a reflectivity of the first mirror layer 132, so that the reflectivity of the reflective electrodes 140 may be greater than the reflectivity of the reflective layer 130, thereby forming the resonant cavity 11 between the first mirror layer 132 and the second mirror layer 142.

Apparently, the reflective layer 130 and the reflective electrodes 140 may alternatively have a single-layer structure capable of forming ohmic contact with the light-emitting epitaxial layer 110 and reflecting light. For example, the reflective electrodes 140 may be a metal aluminum layer, and the reflective layer 130 may be a transparent ITO layer.

In some embodiments, as shown in FIG. 1 and FIG. 2, the LED display substrate 100 may further include a common electrode layer 150. The common electrode layer 150 may be disposed on a side of the reflective layer 130 away from the active layer 112. The common electrode layer 150 may be electrically connected to the first semiconductor layer 111 through the reflective layer 130. In a case where both the mirror layer 132 and the first conductive layer 131 include conductive materials, the common electrode layer 150 may be directly connected to the reflective layer 130 for power supply. In a case where the mirror layer 132 includes an insulating DBR dielectric material, the mirror layer 132 above the region of the first main recessed region 1111 may be removed through etching, so that the common electrode layer 150 may be directly connected to the conductive layer 131 for power supply.

Further, the common electrode layer 150 may define a plurality of windows 151 respectively corresponding to the plurality of first mesa structures 1112. Light output from a side of the reflective layer 130 may be further emitted through the windows 151.

The common electrode layer 150 may be connected to an external circuit to provide a reference voltage to the light-emitting epitaxial layer 110, so that the light-emitting epitaxial layer 110 may be configured to emit light under a combined action of the driving substrate 200 and the common electrode layer 150.

In some embodiments, the common electrode layer 150 may be configured as a common N electrode of the LED display device. The common electrode layer 150 may be configured to transmit voltage and current to the first semiconductor layer 111, so that the current may diffuse to the plurality of display pixels corresponding to the plurality of first mesa structures 1112, thereby enabling the light-emitting epitaxial layer 110 at the display pixels to successfully emit light.

In some embodiments, the common electrode layer 150 may form a bonded metal structure with the reflective layer 130, so that the common electrode layer 150 may form ohmic contact with the first semiconductor layer 111 through the reflective layer 130, thereby better providing current and voltage to the light-emitting epitaxial layer 110. In some embodiments, the common electrode layer 150 may be formed of conductive materials such as Cr, Ti, Ni metals or Au metal, etc.

Based on the above description, a structure of the LED display substrate 100 may include the following three different embodiments.

### A first embodiment

As shown in FIG. 1, the reflective layer 130 may be disposed on a side of the first semiconductor layer 111 away from the active layer 112. The plurality of reflective electrodes 140 may be arranged in an array at intervals on a side of the second semiconductor layer 113 away from the active layer 112.

The first semiconductor layer 111 may be an N-type semiconductor layer, and the second semiconductor layer 113 may be a P-type semiconductor layer. In a case where the light-emitting epitaxial layer 110 undergoes recombination to emit light, electrons in the first semiconductor layer 111 may combine with holes in the second semiconductor layer 113 to generate light. Since the reflectivity of the reflective layer 130 may be less than the reflectivity of the reflective electrodes 140, when the light-emitting epitaxial layer 110 undergoes recombination to emit light, light may be reflected by the reflective electrodes 140 having a higher reflectivity to a side of the reflective layer 130, so that the LED display substrate 100 may be configured to emit light from a side of the first semiconductor layer 111 facing away from the active layer 112.

Further, the first semiconductor layer 111 may include the first main recessed region 1111 and the plurality of first mesa structures 1112. The reflective layer 130 may be disposed on a side of the plurality of first mesa structures 1112 facing away from the active layer 112. The reflective electrodes 140 may be disposed on a side of the second semiconductor layer 113 facing away from the active layer 112. In this way, the light-emitting epitaxial layer 110 corresponding to the plurality of first mesa structures 1112 may form the resonant cavity 11 and may form display pixels emitting light from a side of the first mesa structures 1112. The depth of the first main recessed region 1111 may be less than or equal to the thickness of the first semiconductor layer 111 at the first mesa structures 1112.

Further, the first dielectric cladding layer 120 may wrap or cover sidewalls of the plurality of first mesa structures 1112 facing the first main recessed region 1111 in the first main recessed region 1111 in the first semiconductor layer 111, so as to form a reflective interface at the sidewall of the first main recessed region 1111.

With the above arrangement, when the LED display substrate 100 is energized to emit light, light in the light-emitting epitaxial layer 110 may be reflected and guided by the reflective electrodes 140 to a side of the first semiconductor layer 111. The light, when reaching the sidewall of the first mesa structure 1112, may be reflected back into the first mesa structures 1112 by the reflective interface formed by the first dielectric cladding layer 120. In this way, most of the light generated in the light-emitting epitaxial layer 110 may be concentrated and reflected by the reflective electrodes 140 to a side of the reflective layer 130 to realize light output, thereby improving collimation of light output of the LED display substrate 100. Moreover, arranging the first mesa structures 1112 on a light output surface may enable the reflective interface formed by the first dielectric cladding layer 120 to be formed on the light output side of the light-emitting epitaxial layer 110, thereby further reducing optical crosstalk between display pixels of the LED display substrate 100 and further improving light-emitting efficiency of the LED display substrate 100.

In some embodiments, an insulation region (not shown in the figures) may be formed in portions of the second semiconductor layer 113 and the active layer 112 corresponding to a gap between the plurality of reflective electrodes 140 through performing ion bombardment. In this way, the second semiconductor layer 113 and the active layer 112 that are corresponding to different reflective electrodes 140 may be electrically insulated from each other. With the above arrangement, driving currents among the plurality of display pixels in the light-emitting epitaxial layer 110 may be less likely to influence each other, thereby reducing electrical crosstalk among the plurality of display pixels.

In some embodiments, as shown in FIG. 1, in a case where the common electrode layer 150 is disposed on a side of the reflective layer 130 away from the first semiconductor and the reflective layer 130 includes a conductive material, the common electrode layer 150 may be electrically connected to the reflective layer 130. The common electrode layer 150 may define windows 151 respectively corresponding to the plurality of first mesa structures 1112, and light output from the side of the reflective layer 130 may be further emitted through the windows 151. When the LED display substrate 100 is energized, the common electrode layer 150 may be configured to transmit current to the reflective layer 130, and the current may be transmitted to the first semiconductor layer 111 at the first mesa structures 1112 through the reflective layer 130.

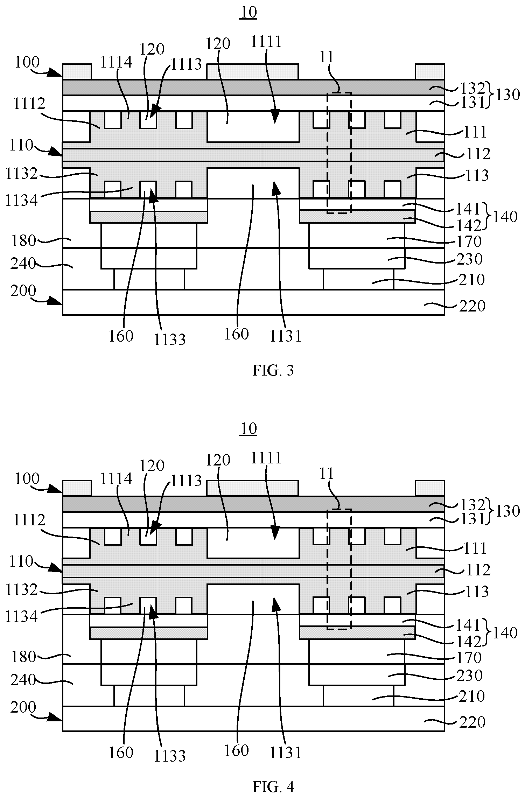

Alternatively, in some other embodiments, as shown in FIG. 3, the reflective layer 130 may be disposed on a side of the first semiconductor layer 111 away from the active layer 112. The LED display substrate 100 may further include a common electrode layer 150. The common electrode layer 150 may be embedded in the first dielectric cladding layer 120 in the first main recessed region 1111 and may be electrically connected to the first semiconductor layer 111.

In some embodiments, during a preparation process of the LED display substrate 100, after etching of the first main recessed region 1111 is completed and the first mesa structures 1112 are formed, a first dielectric cladding layer 120 may be firstly disposed in the first main recessed region 1111. As shown in FIG. 3, the first dielectric cladding layer 120 may cover the sidewalls of the first mesa structures 1112 and the first semiconductor layer 111 at a bottom of the first main recessed region 1111. In this way, the first dielectric cladding layer 120 may completely cover the first semiconductor layer 111 in the first main recessed region 1111 and may reflect leaked light emitted from the sidewalls of the first mesa structures 1112.

Further, the common electrode layer 150 may be further deposited in the first main recessed region 1111. In this way, the common electrode layer 150 may be embedded in the first dielectric cladding layer 120 in the first main recessed region 1111. A surface of the common electrode layer 150 away from the first dielectric cladding layer 120 may be exposed.

In some embodiments, after the common electrode layer 150 is formed, a surface of the first mesa structures 1112 facing away from the epitaxial layer 110 may be polished, so that the surface of the first mesa structures 1112 facing away from the epitaxial layer 110 may be relatively planar. Then, a reflective layer 130 may be further formed on the surface of the first mesa structures 1112 facing away from the epitaxial layer 110. The common electrode layer 150 may form ohmic contact with the first conductive layer 131 of the reflective layer 130. The first conductive layer 131 in the reflective layer 130 may form ohmic contact with the first semiconductor layer 111 at the first mesa structures 1112. For example, the common electrode layer 150 may be a Copper (Cu) layer, and the first conductive layer 131 may be an ITO layer. The common electrode layer 150 and the first conductive layer 131 may be electrically connected to each other.

In some embodiments, when the common electrode layer 150 is energized, the common electrode layer 150 and the first conductive layer 131 in the reflective layer 130 may be configured as an N electrode of the epitaxial layer 110. The common electrode layer 150 may be configured to provide current to the first semiconductor layer 111 through the reflective layer 130.

The common electrode layer 150 may be disposed in the first main recessed region 1111. The common electrode layer 150 may be embedded in the first dielectric cladding layer 120. In this way, not only the reflective layer 130 may be planar to enable light to be relatively collimated when passing through the reflective layer 130, but also an occupied size of the common electrode layer 150 in the thickness direction of the LED display substrate 100 may be reduced, thereby making the LED display substrate 100 thinner.

### A second embodiment

As shown in FIG. 2, the reflective layer 130 may be disposed on a side of the second semiconductor layer 113 away from the active layer 112. The plurality of reflective electrodes 140 may be arranged in an array at intervals on a side of the first semiconductor layer 111 away from the active layer 112.

The second semiconductor layer 113 may be an N-type semiconductor layer, and the first semiconductor layer 111 may be a P-type semiconductor layer. When the light-emitting epitaxial layer 110 undergoes recombination to emit light, electrons from the second semiconductor layer 113 may recombine with holes from the first semiconductor layer 111 to generate light. Since the reflectivity of the reflective layer 130 may be less than the reflectivity of the reflective electrodes 140, when the light-emitting epitaxial layer 110 undergoes recombination to emit light, light may be reflected by the reflective electrodes 140 having a higher reflectivity to a side of the reflective layer 130, thereby achieving light emission from a side of the second semiconductor layer 113 facing away from the active layer 112.

Further, the first semiconductor layer 111 may include the first main recessed region 1111 and the plurality of first mesa structures 1112. The reflective electrodes 140 may be disposed on a side of the plurality of first mesa structures 1112 facing away from the active layer 112. The reflective layer 130 may be spaced apart from the plurality of first mesa structures 1112 by the active layer 112 and the second semiconductor layer 113. The reflective layer 130 may be disposed on a side of the second semiconductor layer 113 facing away from the active layer 112. In this way, the light-emitting epitaxial layer 110 corresponding to the plurality of first mesa structures 1112 may form the resonant cavity 11. The LED display substrate 100 may form display pixels that are configured to emit light from a side of the second semiconductor layer 113.

The first dielectric cladding layer 120 may wrap or cover sidewalls of the plurality of first mesa structures 1112 facing the first main recessed region 1111 in the first main recessed region 1111 in the first semiconductor layer 111, so as to form a reflective interface at the sidewalls of the first main recessed region 1111.

With the above arrangement, the reflective interface formed by the first dielectric cladding layer 120 may, together with the reflective electrodes 140, reflect light corresponding to the first mesa structures 1112, so that light of the LED display substrate 100 may be concentrated to be emitted from a side of the reflective layer 130, thereby improving collimation of emitted light. Further, a light output surface may be arranged on a side of the second semiconductor layer 113 facing away from the active layer 112, which may enable a light-emitting side to be more planar, thereby further improving collimation of emitted light and facilitating adding the reflective layer 130 and other functional components on the light output side of the second semiconductor layer 113 during preparation of the LED display device 10.

In some embodiments, ion bombardment may be performed on the first semiconductor and the active layer 112 corresponding to the first main recessed region 1111 to form insulating regions (not shown in the figures), so that electrical isolation may be achieved between the first semiconductor and the active layer 112 corresponding to the plurality of first mesa structures 1112. With such an arrangement, driving currents among the plurality of display pixels in the light-emitting epitaxial layer 110 may be less likely to influence each other, thereby reducing electrical crosstalk among the plurality of display pixels.

In some embodiments, as shown in FIG. 2, the common electrode layer 150 may be disposed on a side of the reflective layer 130 away from the second semiconductor, and the common electrode layer 150 may form a bonding structure with the reflective layer 130, so as to form ohmic contact with the reflective layer 130. The common electrode layer 150 together with the reflective layer 130 may be configured as an N electrode of the light-emitting epitaxial layer 110, and a reference current may be provided to the second semiconductor through the reflective layer 130.

The common electrode layer 150 may substantially have a grid shape and may be provided with a plurality of windows 151 respectively corresponding to the plurality of first mesa structures 1112. In this way, the windows 151 may correspond to the plurality of display pixels, and the common electrode layer 150 may not block light emitted from the plurality of display pixels when the light-emitting epitaxial layer 110 emits light. The grid-shaped common electrode layer 150 may further define positions of the display pixels, thereby reducing optical crosstalk among the display pixels.

### A third embodiment

In addition to the first mesa structures 1112 of the first semiconductor layer 111 described above, mesa structures may be further disposed in the second semiconductor layer 113. In this way, mesa structures may be disposed in both the first semiconductor layer 111 and the second semiconductor layer 113, as described below.

As shown in FIG. 4, a side of the second semiconductor layer 113 away from the active layer 112 may define, a second main recessed region 1131 and a plurality of second mesa structures 1132. The plurality of second mesa structures 1132 may be arranged in an array and spaced apart from each other by the second main recessed region 1131.

The second mesa structures 1132 may correspond to the first mesa structures 1112, so that the plurality of second mesa structures 1132 may correspond to the plurality of display pixels. A depth of the second main recessed region 1131 may be less than or equal to a thickness of the second semiconductor layer 113 at the second mesa structures 1132. In this way, during etching of the light-emitting epitaxial layer 110 to form the second main recessed region 1131, the active layer 112 may be less likely to be etched and damaged, thereby ensuring a light-emitting intensity of the LED display device 10.

In some embodiments, as shown in FIG. 4, the LED display substrate 100 may further include a second dielectric cladding layer 160. The second dielectric cladding layer 160 may be disposed in the second main recessed region 1131 and may be in contact with sidewalls of the second mesa structures 1132. A refractive index of the second dielectric cladding layer 160 may be different from a refractive index of the second semiconductor layer 113, thereby forming a reflective interface between the sidewalls of the second mesa structures 1132 and the second dielectric cladding layer 160. In some embodiments, the second dielectric cladding layer 160 may, for example, include a dielectric material such as SiO2 and etc., which is the same as the first dielectric cladding layer 120.

During a process in which the light-emitting epitaxial layer 110 generates light, light may be generated in the light-emitting epitaxial layer 110 within the display pixels. When the light reaches the sidewalls of the second mesa structures 1132 and the sidewalls of the first mesa structures 1112, the second dielectric cladding layer 160 and the first dielectric cladding layer 120 may reflect the light back into the second mesa structures 1132 and the first mesa structures 1112. In this way, the reflective electrodes 140 having higher reflectivity may be configured to reflect the light in the light-emitting epitaxial layer 110 to a side of the reflective layer 130, thereby allowing the light to exit the cavity from a side of the reflective layer 130.

The mesa structures may be disposed in both the first semiconductor layer 111 and the second semiconductor layer 113. The dielectric cladding layers may be disposed on the sidewalls of the mesa structures. In this way, light within the display pixels, when propagating in the light-emitting epitaxial layer 110, may be concentrated and reflected by the reflective electrodes 140, thereby further improving collimation of light output of the LED display substrate 100 and further improving light-emitting efficiency of the LED display substrate 100.

For example, in a case where the second semiconductor layer 113 is configured as a P electrode, the second mesa structures 1132 and the second main recessed region 1131 may be disposed on a side close to the reflective electrodes 140. Further, a side of the second mesa structures 1132 away from the active layer 112, may be electrically connected to the reflective electrodes 140. A structure of the second semiconductor layer 113 may refer to the structure of the first semiconductor layer 111 in the second embodiment, and details are not repeated herein.

In some embodiments, in a case where the second semiconductor layer 113 is configured as an N electrode, the second mesa structures 1132 and the second main recessed region 1131 may be disposed on a side close to the reflective layer 130. Further, a side of the second mesa structures 1132 away from the active layer 112, may be electrically connected to the reflective electrodes 140 and may be connected to the common electrode layer 150. A structure of the second semiconductor layer 113 may refer to the structure of the first semiconductor layer 111 in the first embodiment, and details are not repeated herein.

In some embodiments, mesa structures in the above three embodiments may further include a plurality of sub-mesa structures. The following describes, by taking the LED display device 10 shown in the third embodiment as an example, the sub-mesa structures in the mesa structures.

As shown in FIG. 4, in some embodiments, first auxiliary recessed regions 1113 may be formed or defined on a side of the first mesa structures 1112 away from the active layer 112, so as to divide the first mesa structures 1112 into a plurality of first sub-mesa structures 1114. Depths of the first auxiliary recessed regions 1113 may be less than or equal to a thickness of the first semiconductor layer 111 at the first sub-mesa structures 1114. The first dielectric cladding layer 120 may be further disposed in the first auxiliary recessed region 1113 and may be in contact with sidewalls of the plurality of first sub-mesa structures 1114.

In some embodiments, in a case where the reflective electrode 140 or the reflective layer 130 covers a side of the first mesa structures 1112 away from the epitaxial layer 110, the reflective electrode 140 or the reflective layer 130 may further cover the plurality of first sub-mesa structures 1114 and the first auxiliary recessed region 1113. Since the light-emitting epitaxial layer 110 corresponding to the first mesa structures 1112 may be configured as one display pixel, the plurality of first sub-mesa structures 1114 corresponding thereto may form a plurality of small resonant cavities 11, thereby further improving collimation of emitted light.

In some embodiments, as shown in FIG. 4, the first dielectric cladding layer 120 may fill the first auxiliary recessed region 1113 to form full contact with the sidewalls of the plurality of first sub-mesa structures 1114, thereby forming reflective interfaces at the sidewalls of the plurality of first sub-mesa structures 1114. When the display pixels emit light, during a process in which the reflective electrode 140 reflects light toward a side of the reflective layer 130, a propagation angle of the light may be further corrected when the light propagates within the plurality of first sub-mesa structures 1114, so that light output of the LED display substrate 100 may be more collimated.

In some embodiments, as shown in FIG. 4, a second auxiliary recessed region 1133 may be formed or defined on a side of the second mesa structures 1132 away from the active layer 112, so as to divide the second mesa structures 1132 into a plurality of second sub-mesa structures 1134. A depth of the second auxiliary recessed region 1133 may be less than or equal to a thickness of the second semiconductor layer 113 at the second sub-mesa structures 1134. The second dielectric cladding layer 160 may be further disposed in the second auxiliary recessed region 1133 and may be in contact with sidewalls of the plurality of second sub-mesa structures 1134.

The plurality of second sub-mesa structures 1134 may correspond to the plurality of first sub-mesa structures 1114. The reflective layer 130 and the reflective electrodes 140 may respectively cover sides of the first mesa structures 1112 and the second mesa structures 1132 away from the active layer 112. In this way, the plurality of second sub-mesa structures 1134 in the first mesa structures 1112 and the second mesa structures 1132 may, together with the plurality of first sub-mesa structures 1114, form a plurality of resonant cavities 11. As a result, when the display pixels corresponding to the first mesa structures 1112 and the second mesa structures 1132 emit light, the plurality of resonant cavities 11 may further improve collimation of emitted light.

In some embodiments, as shown in FIG. 4, the second dielectric cladding layer 160 may fill the second auxiliary recessed region 1133 to be fully contact with the sidewalls of the plurality of second sub-mesa structures 1134, thereby forming reflective interfaces at the sidewalls of the plurality of second sub-mesa structures 1134.

In a case where the light-emitting epitaxial layer 110 corresponding to the display pixels emits light, after light inside the light-emitting epitaxial layer 110 is reflected by the reflective electrodes 140, propagation angles of the light may be further corrected multiple times by reflective interfaces at the sidewalls of the plurality of first sub-mesa structures 1114 and the plurality of second sub-mesa structures 1134, so that the light may be collimated when emitted from a side of the reflective layer 130.

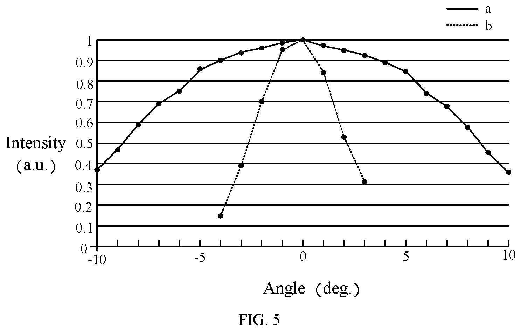

As shown in FIG. 5, curve a in FIG. 5 may represent a light output effect of one display pixel without a plurality of resonant cavities 11, and curve b in FIG. 5 may represent a light output effect of one display pixel with a plurality of resonant cavities 11. By comparing curve a and curve b, it may be seen that the display pixel having the plurality of resonant cavities 11 may produce a more collimated light output.

With the above arrangement, the LED display substrate 100 may achieve collimated light output under combined effects of the reflective layer 130, the reflective electrodes 140, reflective interfaces at the sidewalls of the first mesa structures 1112, reflective interfaces at the sidewalls of the second mesa structures 1132, reflective interfaces at the sidewalls of the first sub-mesa structures 1114, and reflective interfaces at the sidewalls of the second sub-mesa structures 1134, thereby further improving collimation of light output of the LED display substrate 100 and improving light-emitting efficiency of the LED display substrate 100.

Furthermore, sizes of the display pixels may be adjusted in a lateral direction. In this way, while ensuring that the display pixels produce collimated light output through the resonant cavities 11 surrounded by cladding materials on multiple side surfaces, lateral dimensions of the display pixels may be reduced, thereby reducing an overall size of the LED display device 10.

Apparently, in some other embodiments, the sub-mesa structures may be provided in either the first mesa structures 1112 or the second mesa structures 1132, and details are not enumerated herein.

In some embodiments, as shown in FIGS. 1-4, the LED display substrate 100 may further include a plurality of first bonding electrodes 170 and a first filling layer 180. The driving substrate 200 may further include a substrate body 220, a plurality of second bonding electrodes 230, and a second filling layer 240.

The plurality of first bonding electrodes 170 may be disposed on surfaces of the plurality of reflective electrodes 140 facing away from the light-emitting epitaxial layer 110. The plurality of first bonding electrodes 170 may respectively correspond to and be electrically connected to the plurality of reflective electrodes 140. The first filling layer 180 may cover surfaces of the reflective electrodes 140 facing away from the light-emitting epitaxial layer 110 and sidewalls of the first bonding electrodes 170, thereby fixing the plurality of first bonding electrodes 170 and the plurality of reflective electrodes 140.

As shown in FIGS. 1-4, the plurality of power supply electrodes 210 may be fixed on a surface of the substrate body 220. The plurality of second bonding electrodes 230 may be disposed on surfaces of the plurality of power supply electrodes 210 facing away from the substrate body 220. The plurality of second bonding electrodes 230 may respectively correspond to and be electrically connected to the plurality of power supply electrodes 210. The second filling layer 240 may cover the surfaces of the plurality of power supply electrodes 210 facing away from the substrate body 220 and sidewalls of the first bonding electrodes 170, thereby fixing the plurality of second bonding electrodes 230 and the plurality of power supply electrodes 210.

The plurality of first bonding electrodes 170 may respectively correspond to the plurality of second bonding electrodes 230. Surfaces of the plurality of first bonding electrodes 170 facing away from the reflective electrodes 140 may form metallic bonding with surfaces of the plurality of second bonding electrodes 230 facing away from the power supply electrodes 210. In this way, the plurality of first bonding electrodes 170 and the plurality of second bonding electrodes 230 may be electrically connected to each other. In this way, the plurality of reflective electrodes 140 and the plurality of power supply electrodes 210 may be electrically connected to each other through the corresponding first bonding electrodes 170 and second bonding electrodes 230. The driving substrate 200 may provide driving current to the light-emitting epitaxial layer 110 sequentially through the power supply electrodes 210, the second bonding electrodes 230, the first bonding electrodes 170, and the reflective electrodes 140.

Through arranging the second bonding electrodes 230 and the first bonding electrodes 170 between the reflective electrodes 140 and the power supply electrodes 210 in a bonded structure, a fixing effect between the reflective electrodes 140 and the power supply electrodes 210 may be improved, thereby achieving higher-strength connection and improving stability of an internal structure of the LED display device 10.

In some embodiments, a surface of the first filling layer 180 facing away from the light-emitting epitaxial layer 110 may be bonded with a surface of the second filling layer 240 facing away from the substrate body 220, thereby enabling a stable connection between the driving substrate 200 and the LED display substrate 100.

In some embodiments, the first filling layer 180 and the second filling layer 240 may be oxide layers made of silicon dioxide or other insulating materials. The power supply electrodes 210, the first bonding electrodes 170, and the second bonding electrodes 230 may be electrodes made of copper metal or other conductive materials. The substrate body 220 may be a Complementary Metal Oxide Semiconductor (CMOS) substrate.

As described above, in some embodiments of the present disclosure, the first semiconductor layer 111 of the light-emitting epitaxial layer 110 for generating light may be provided with the first main recessed region 1111 to form the plurality of first mesa structures 1112. The reflective layer 130 and the plurality of reflective electrodes 140 may be disposed on two sides of the plurality of first mesa structures 1112, so that the plurality of first mesa structures 1112 may form a plurality of display pixels. The reflectivity of the reflective layer 130 may be less than the reflectivity of the reflective electrodes 140, so that the reflective electrodes 140 may reflect light from the light-emitting epitaxial layer 110 to a side of the reflective layer 130, thereby enabling the light-emitting epitaxial layer 110 at the plurality of first mesa structures 1112 to form the resonant cavity 11 emitting light from the side of the reflective layer 130, thereby improving collimation of light output of the LED display substrate 100 and improving light-emitting efficiency. Furthermore, the first dielectric cladding layer 120 may be disposed in the first main recessed region 1111 and may be in contact with sidewalls of the first mesa structures 1112, and the refractive index of the first dielectric cladding layer 120 may be different from that of the first semiconductor layer 111, so that a reflective interface may be formed at the sidewalls of the first mesa structures 1112. In a case where display pixels corresponding to the first mesa structures 1112 emit light, the first dielectric cladding layer 120 may be configured to reflect light generated within the first mesa structures 1112 back into the resonant cavity 11 at the sidewalls of the first mesa structures 1112. In this case, the reflective electrodes 140 having higher reflectivity may further reflect the light to a side of the reflective layer 130, thereby reducing light leakage from the sidewalls of the first mesa structures 1112, and further improving collimation of light output and improving light-emitting efficiency of the LED display substrate 100.

The above descriptions are only some embodiments of the present disclosure and are not intended to limit the scope of the present disclosure. Any equivalent structures or equivalent process transformations made by using the contents of the description and drawings of the present disclosure, or directly or indirectly applied to other related technical fields, shall fall within the protection scope of the present disclosure.

## Claims

1. A light-emitting diode, LED, display substrate, comprising:
a light-emitting epitaxial layer, comprising a first semiconductor layer, an active layer, and a second semiconductor layer sequentially stacked on one another, wherein a side of the first semiconductor layer away from the active layer defines a first main recessed region and a plurality of first mesa structures, the plurality of first mesa structures are arranged in an array and spaced apart from each other by the first main recessed region, and a depth of the first main recessed region is less than or equal to a thickness of the first semiconductor layer at the first mesa structures;
a first dielectric cladding layer, disposed in the first main recessed region and in contact with sidewalls of the first mesa structures, wherein a refractive index of the first dielectric cladding layer is different from a refractive index of the first semiconductor layer, so as to form a reflective interface between the first dielectric cladding layer and the sidewalls of the first mesa structures;
a reflective layer, disposed on a side of one of the first semiconductor layer and the second semiconductor layer facing away from the active layer; and
a plurality of reflective electrodes, arranged in an array at intervals on a side of the other one of the first semiconductor layer and the second semiconductor layer facing away from the active layer, and respectively corresponding to the plurality of first mesa structures, wherein a reflectivity of the reflective layer is less than a reflectivity of the reflective electrodes, so as to form a resonant cavity that is configured to emit light from a side of the reflective layer.

2. The LED display substrate as claimed in claim 1, wherein an absolute value of a difference between the refractive index of the first dielectric cladding layer and the refractive index of the first semiconductor layer is greater than or equal to 0.8.

3. The LED display substrate as claimed in claim 1, wherein the first dielectric cladding layer is formed through a deposition manner.

4. The LED display substrate as claimed in claim 1, wherein the first dielectric cladding layer is configured to be in full contact with the sidewalls of the first mesa structures along a circumferential direction of the first mesa structures.

5. The LED display substrate as claimed in claim 1, wherein first auxiliary recessed regions are defined on a side of the first mesa structures away from the active layer, so as to divide the first mesa structures into a plurality of first sub-mesa structures, depths of the first auxiliary recessed regions are less than or equal to a thickness of the first semiconductor layer at the first sub-mesa structures, and the first dielectric cladding layer is further disposed in the first auxiliary recessed regions and is in contact with sidewalls of the plurality of first sub-mesa structures.

6. The LED display substrate as claimed in claim 5, wherein the first dielectric cladding layer is configured to be in full contact with the sidewalls of the first sub-mesa structures along a circumferential direction of the first sub-mesa structures.

7. The LED display substrate as claimed in claim 1, wherein a side of the second semiconductor layer away from the active layer defines a second main recessed region and a plurality of second mesa structures, the plurality of second mesa structures are arranged in an array and spaced apart from each other by the second main recessed region, and the second mesa structures correspond to the first mesa structures;
a depth of the second main recessed region is less than or equal to a thickness of the second semiconductor layer at the second mesa structures, and the LED display substrate further comprises a second dielectric cladding layer, the second dielectric cladding layer is disposed in the second main recessed region and in contact with sidewalls of the second mesa structures;
a refractive index of the second dielectric cladding layer is different from a refractive index of the second semiconductor layer, thereby forming a reflective interface between the sidewalls of the second mesa structures and the second dielectric cladding layer.

8. The LED display substrate as claimed in claim 7, wherein second auxiliary recessed regions are defined on a side of the second mesa structures away from the active layer, so as to divide the second mesa structures into a plurality of second sub-mesa structures, depths of the second auxiliary recessed regions are less than or equal to a thickness of the second semiconductor layer at the second sub-mesa structures, and the second dielectric cladding layer is further disposed in the second auxiliary recessed regions and is in contact with sidewalls of the plurality of second sub-mesa structures.

9. The LED display substrate as claimed in claim 1, further comprising a common electrode layer, the common electrode layer is disposed on a side of the reflective layer away from the active layer, and the common electrode layer is electrically connected, through the reflective layer, to one of the first semiconductor layer and the second semiconductor layer;
the common electrode layer defines a plurality of windows respectively corresponding to the plurality of first mesa structures, and light output from the side of the reflective layer is further emitted through the windows.

10. The LED display substrate as claimed in claim 1, wherein the reflective layer is disposed on a side of the first semiconductor layer away from the active layer; and
the LED display substrate further comprises a common electrode layer, the common electrode layer is embedded in the first dielectric cladding layer in the first main recessed region, and the common electrode layer is electrically connected to the first semiconductor layer.

11. An LED display device, comprising:
the LED display substrate as claimed in any one of claims 1-10; and
a driving substrate, comprising a plurality of power supply electrodes arranged in an array at intervals, wherein the LED display substrate is fixed on the driving substrate, and the power supply electrodes are electrically connected to the corresponding reflective electrodes, so as to form display pixels corresponding to the first mesa structures.
